# EUROPÄISCHE PATENTSCHRIFT

(11) **EP 2 356 478 B1**
(45) Veröffentlichungstag und Bekanntmachung des Hinweises auf die Patenterteilung: **26.12.2012**
(21) Anmeldenummer: 09804231.0
(22) Anmeldetag: 18.11.2009
(51) Int. Cl.: G01R 33/035

(54) **SQUID-SYSTEM MIT ERHÖHTER FLUSS-SPANNUNGS-TRANSFERFUNKTION**
SQUID SYSTEM HAVING INCREASED FLUX VOLTAGE TRANSFER FUNCTION
SYSTÈME SQUID À FONCTION DE TRANSFERT FLUX-TENSION ACCRUE

(30) Priorität: 19.11.2008 DE 102008058308
(43) Veröffentlichungstag der Anmeldung: 17.08.2011
(73) Patentinhaber: Institut für Photonische Technologien e.V., 07745 Jena (DE)
(72) Erfinder: ZAKOSARENKO, Vyacheslav, 07743 Jena (DE); STOLZ, Ronny, 99510 Apolda (DE); MAYER, Hans-Georg, 07749 Jena (DE)
(74) Vertreter: Pfeiffer, Rolf-Gerd
(86) Internationale Anmeldenummer: PCT/DE2009/001655
(87) Internationale Veröffentlichungsnummer: WO 2010/057487

(56) Entgegenhaltungen:
- US-B1- 6 690 162
- KORNEV V K ET AL: "Development of SQIF-Based Output Broad Band Amplifier" IEEE TRANSACTIONS ON APPLIED SUPERCONDUCTIVITY, IEEE SERVICE CENTER, LOS ALAMITOS, CA, US, Bd. 17, Nr. 2, 1. Juni 2007 (2007-06-01), Seiten 569-572, XP011188322 ISSN: 1051-8223

## Beschreibung

Die Erfindung betrifft ein SQUID-System mit erhöhter Fluss-Spannungs-Transferfunktion.

Dabei bezieht sich vorliegende Erfindung auf einen supraleitenden Quanteninterferenzdetektor (Superconducting Quantum Interference Device, dc SQUID), welcher der sehr empfindlichen Messung des magnetischen Flusses und anderer physikalischer Größen, die sich in magnetischen Fluss konvertieren lassen (wie z.B. Magnetfeld, Magnetfeldgradient, elektrischer Strom, u.a.) dient.

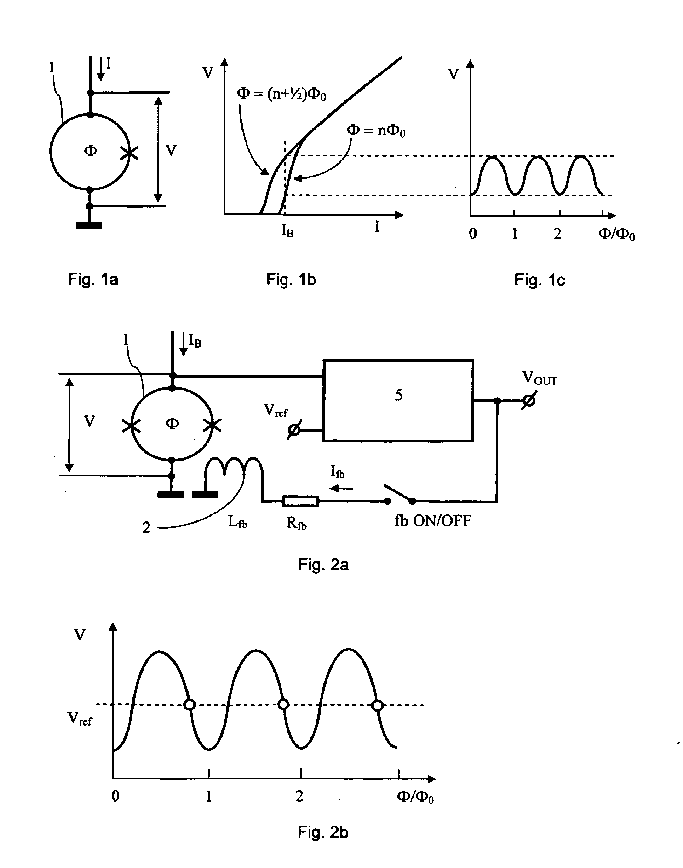

Supraleitende Quanteninterferenzdetektoren (Superconducting Quantum Interference Device, dc SQUID) stellen die zurzeit empfindlichsten Detektoren zur Bestimmung eines magnetischen Flusses dar. Ihre Funktion basiert auf zwei physikalischen Phänomenen, nämlich der Quantisierung des magnetischen Flusses in einem supraleitenden Ring und dem Josephson-Effekt von zwei schwach gekoppelten Supraleitern. Ein SQUID ist ein von einem oder mehreren Josephson-Kontakten unterbrochener supraleitender Ring. Es sind zwei grundlegende Arten von SQUIDs bekannt [vgl. A. Barone, G. Paterno: "Physics and Application of the Josephson Effect" A Wiley-Interscience Publication, John Wiley & Sons, New York (1982)], nämlich rf SQUID und dc SQUID. Ein supraleitender Ring mit nur einem Josephson-Kontakt nennt sich rf SQUID. Er ist an einen RadioFrequenz-Schwingkreis gekoppelt und wird üblicherweise mit rf Fluss betrieben. Der von zwei oder mehr Josephson-Kontakten unterbrochene Ring wird als dc SQUID bezeichnet, weil er meistens mit einem durch beide Kontakte fließenden Gleichstrom betrieben wird (vgl. hier Fig. 1a). Vorliegende Erfindung bezieht sich auf den Einsatz eines dc SQUID als sensitivem Element.

Der kritische Strom des Josephson-Kontakts ist eine periodische Funktion der über dem Kontakt auftretenden Phasendifferenz der Wellenfunktion der durch die Kontakte tretenden Ladungsträger. Der den Ring durchsetzende magnetische Fluss bestimmt die Phasendifferenz. Dabei ist eine charakteristische Größe ein magnetisches Flussquant Φ₀ = h/2e = 2.0710 - 10⁻¹⁵Vs. Daraus resultiert die periodische Abhängigkeit des kritischen Stromes vom Fluss mit der Periode eines magnetischen Flussquants Φ₀ (vgl. Fig. 1b). Bei Betrieb des SQUID mit einem Gleichstrom ist die über den Josephson-Kontakten abfallende Spannung ebenfalls eine periodische Funktion des den Ring durchsetzenden magnetischen Flusses (vgl. Fig. 1c). Deshalb ist der SQUID ein Fluss-Spannungs-Wandler. Der typische Spannungshub derzeit verfügbarer SQUIDs beträgt etwa 50µV und der maximale Wert der Transferfunktion ist ungefähr 200µV/Φ₀. Mit typischen SQUIDs können Änderungen des magnetischen Flusses von weit weniger als einem Flussquant Φ₀ gemessen werden. Das intrinsische SQUID-Rauschen kann in der Größenordnung von 10⁻⁶Φ₀/Hz^{1/2} sein [T. Ryhänen, H. Seppä, R. Ilomoniemi and J. Knuutila: "SQUID Magnetometers fro Low-Frequency Applications" J. Low Temp. Physics, 76, S. 287-386 (1989)].

Um einen SQUID-Sensor verwenden zu können, ist es notwendig, die periodische Fluss-Spannungs-Kennlinie zu linearisieren. Das Standardverfahren dafür ist, den SQUID als Nulldetektor zu verwenden. Dazu wird eine zu messende Flussänderung über einen Strom durch eine Spule (Rückkoppelspule oder feedback-Spule), die induktiv an den SQUID angekoppelt ist, kompensiert. Als Beispiel einer solchen, nach dem Stand der Technik bekannten Lösung, wird in Fig. 2a gezeigt. Dort ist ein SQUID zusammen mit der Ausleseelektronik, der so genannten Rückkoppelelektronik oder Regelschleife, schematisch dargestellt. Die Rückkoppelelektronik 5 nimmt die Spannung (V) vom SQUID 1 ab, vergleicht sie mit einer Referenzspannung (V_{ref}) und verstärkt die Differenz. Falls der Schalter für den Feedback (fb ON/OFF) geschlossen ist, fließt ein Rückkoppelstrom (I_{fb}) durch die Rückkoppelspule 2, welcher die durch ein Signal bewirkte Flussänderung kompensiert und so den Gesamtfluss im SQUID konstant hält. Das bedeutet, dass der SQUID einen stabilen Punkt auf der Fluss-Spannungs-Kennlinie (einer der Kreise in der Fig. 2b) einnimmt. Wegen der periodischen Kennlinie, existieren nun viele dieser stabilen Arbeitspunkte, die durch eine ganzzahlige Anzahl von magnetischen Flussquanten voneinander entfernt sind. Ein SQUID zusammen mit dieser gezeigten Rückkoppelelektronik ist bekannt als so genannter Flux-locked-loop (FLL). Die Ausgangsspannung der FLL (V_{OUT}) ist direkt proportional zum Strom (I_{fb}), der zur Kompensation des Signal-Flusses benötigt wird.

Es sind zwei grundlegende Arten der FLL-Elektronik bekannt, nämlich: flussmodulierte Elektronik und direkt gekoppelte Elektronik [J. Clarke, A. Braginski: "The SQUID Handbook" WILEY-VCH Verlag GmbH & Co. KGaA, Weinheim, (2006)].

Erstere nutzt die Methode der Flussmodulation, um ein Wechselspannungssignal eines mit Gleichstrom betriebenen dc SQUID zu erhalten. Ein Transformator-Netzwerk sorgt für die Anpassung der Impedanzen des niederohmigen SQUID an den hochohmigen Eingang der ersten Verstärkerstufe der FLL-Elektronik. Nach der Demodulation und Integration wird das Signal als Strom durch die Rückkoppelspule geleitet. Bei dieser Elektronik werden Bandbreite und Signalfolgegeschwindigkeit (slew rate) durch die Modulationsfrequenz begrenzt, weshalb sie für viele Anwendungen nicht geeignet ist.

Die direkt gekoppelte Elektronik funktioniert potentiell auch bei höheren Frequenzen und Signalfolgegeschwindigkeiten. Der wesentliche Nachteil dieser Elektronik ist jedoch die fehlende Anpassung der Impedanz zwischen SQUID und dem Verstärkereingang. Deshalb spielen das intrinsische Rauschen der Elektronik sowie Driften eine wichtige Rolle in der rauschsbegrenzten Auflösung des Systems. Diese Probleme treten vor allem bei niedrigen Frequenzen auf, wodurch die Anwendung in einigen Fällen eingeschränkt wird. Neben der Entwicklung extrem rauscharmer Elektroniken stellt die Erhöhung der SQUID-Transferfunktion eine Möglichkeit dar, das Problem des Elektronikrauschens zu umgehen. Dies ist der Grund, weshalb bereits mehrere Versuche unternommen wurden, die Fluss-Spannungs-Transferfunktion zu erhöhen.

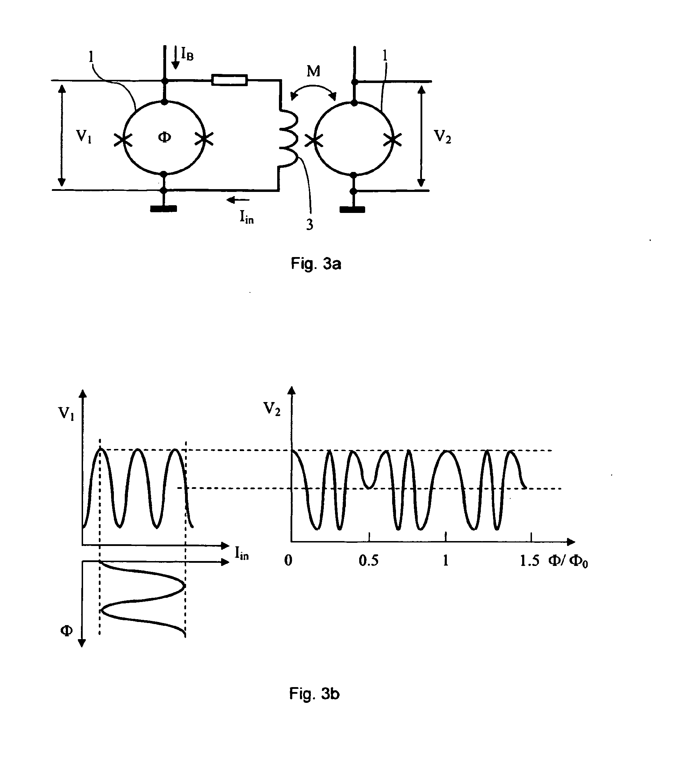

Ein möglicher Weg die Transferfunktion zu erhöhen, ist die Verwendung eines Mehrstufen-Systems, bei dem das Signal des SQUIDs der ersten Stufe durch eine zweite Stufe verstärkt wird. Die zweite Stufe kann ein einzelner SQUID (vgl. Fig. 3a) oder auch ein Array von vielen in Reihe geschalteter und bzgl. der geometrischen Ausbildung und der elektrischen Parameter untereinander identischer SQUIDs sein [vgl.: R.P Welty, J.M. Martinis: "Two-stage integrated SQUID amplifier with series array output" IEEEE Trans. Applied Superconductivity, 3, S. 2605-2608 (1993) und R. Cantor, L.P. Lee, A. Matlashov, V. Vinetskiy: "A Low-Noise, Two-Stage DC SQUID Amplifier with High Bandwidth and Dynamic Range", IEEE Trans. Applied Supercond. 7, S. 3033-3036 (1997)].

Die somit nach dem Stand der Technik erreichbare Erhöhung der Fluss-Spannungs-Transferfunktion ist in Fig. 3b beispielhaft dargestellt. Ein Nachteil eines solchen Zweistufensystems ist ebenfalls aus Fig. 3b ersichtlich. Die resultierende Fluss-Spannungs-Kennlinie ist aufgrund der Periodizitäten von SQUID und SQUID-Array sehr kompliziert und führt zu einer Vielzahl von stabilen Arbeitspunkten der FLL mit jeweils verschiedenen Transferfunktionen und Rauscheigenschaften.

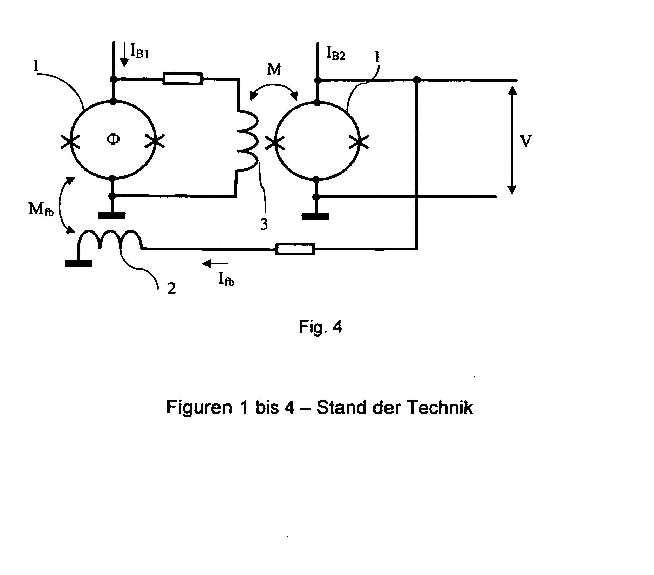

Eine andere Möglichkeit, die Fluss-Spannungs-Kennlinie zu linearisieren, ist die direkte Rückkopplung des Ausgangssignals eines Mehrstufen-SQUIDsystems. Dieser Ansatz wurde in K.D. Irwin, M.E. Hubert: "SQUID Operational Amplifier", IEEE Trans. Applied Supercond. 11, 1265-1270 (2001) verfolgt. Die Idee dieses Ansatzes, ist die Rückkopplung eines Teils des Betriebsstromes (I_{B2}) der letzten SQUID-Array-Stufe in die Rückkoppelspule des SQUID der ersten Stufe (siehe Fig. 4). Die sich auf Zimmertemperatur befindende Ausleseelektronik reduziert sich somit auf einen einfachen Verstärker. Der Nachteil dieses Ansatzes bleibt allerdings der gleiche. Wird die Flussregelschleife aufgrund äußerer Störungen aufgebrochen, stellt sich ein neuer, nicht vorhersehbarer Arbeitspunkt ein.

Für einen völlig anderen Verwendungszweck, nämlich der der hochpräzisen absoluten Messung von zeitveränderlichen Magnetfeldern, wurde in jüngerer Zeit ein neuer Typ einer supraleitenden Vielkontakt-Anordnung, genannt Superconducting Quantum Interference Filter (SQIF), vorgeschlagen [EP 1 135 694 B1; DE 100 43 657 A1]. Bei diesem Vorschlag handelt sich im Wesentlichen um ein Array vieler unterschiedlich ausgebildeter SQUIDs, welche entweder parallel oder in Reihe geschalten sind. Durch eine besondere Verteilung der SQUID-Flächen kann eine Fluss-Spannungs-Kennlinie mit nur einem Extremum (Maximum des kritischen Stromes oder Minimum der Spannung bei konstantem Betriebsstrom) erreicht werden. Dieses Extremum liegt in der Nähe des Punktes, an dem der Fluss in jeder den SQIF formenden Schleifen Null ist. Dies erlaubt die absolute Messung des magnetischen Flusses bzw. Feldes, wohingegen mit Standard SQUID-Systemen nur Änderungen des magnetischen Flusses messbar sind. Eine detaillierte Beschreibung des SQIF in Aufbau und Funktion ist in J. Oppenländer, Th.Träuble, Ch. Häussler, N. Schopohl: "Superconducting Multiloop Quantum Interferometer", IEEE Trans. Applied Supercond. 11, S. 1271-1274 (2001) zu finden.

Folgende Veröffentlichungen offenbaren auch SQUIDs mit nachgeordneten SQIFs:
- D1: KORNEV V K ET AL: "Development of SQIF-Based Output Broad Band Amplifier", IEEE TRANSACTIONS ON APPLIED SUPERCONDUCTIVITY, IEEE SERVICE CENTER, LOS ALAMITOS, CA, US, Bd. 17, Nr. 2, 1. Juni 2007 (2007-06-01), Seiten 569-572, XP011188322, ISSN: 1051-8223.
- D2: US 6 690 162 B1 (SCHOPOHL NILS [DE] ET AL) 10. Februar 2004 (2004-02-10).

Vorliegender Erfindung liegt die Aufgabe zugrunde, eine Schaltungsanordnung anzugeben, die eine erhöhte Fluss-Spannungs-Transferfunktion eines dc SQUID liefert, wodurch die Messempfindlichkeit des Systems spürbar erhöht und die erforderliche Ausleseelektronik vereinfacht wird.

Die Aufgabe wird durch die Merkmale des Anspruchs 1 gelöst. Vorteilhafte Ausgestaltungen sind Gegenstand der nachgeordneten Ansprüche.

In vorliegender Erfindung wird der Einsatz eines SQIF als Stromsensor mit einer supraleitenden Spule am Eingang als zweiter Stufe in einer zweistufigen Auslese des SQUID vorgeschlagen, wobei das SQIF Design erfindungsgemäß grundsätzlicher Veränderungen zu unterziehen ist, die in der speziellen Beschreibung detaillierter ausgeführt werden.

Das Wesen der Erfindung besteht darin, dass zumindest ein SQIF als Verstärkerschaltung vorgesehen ist, welches dem ersten dc SQUID nachgeordnet ist, wobei allen Schleifen des SQIF eine mit dem ersten SQUID elektrisch verbundene Einkoppelspule, zwecks induktiver Ankopplung, direkt zugeordnet ist.

Die Erfindung soll nachstehend anhand detaillierter Ausführungsbeispiele und zugehöriger Figuren näher erläutert werden. Es zeigen:
- Fig. 1a:: einen einzelnen dc SQUID 1;
- Fig. 1b:: die Strom-Spannungs-Kennlinie (1-V-Kennlinie) des dc SQUID für die zwei Extremalwerte des Flusses (Φ) im SQUID, wobei Φ₀ für ein Flussquant steht;
- Fig. 1c:: eine Fluss-Spannungs-Kennlinie (Φ-V-Kennlinie) des SQUID, wenn es mit einem Betriebsstrom I_{B} gespeist wird;
- Fig. 2a:: einen dc SQUID 1 mit Rückkoppelelektronik. Falls der Schalter fb ON/OFF geschlossen (Stellung "ON") ist, erzeugt die Elektronik einen Strom I_{fb} proportional zur Spannungsdifferenz V-V_{ref} durch den Widerstand R_{fb} und die Rückkoppelspule 2;
- Fig. 2b:: die SQUID-Spannung als Funktion des Flusses im SQUID. Der Rückkoppelkreis hält den Gesamtfluss im SQUID konstant in der Nähe der Arbeitspunkte, die durch die Kreise gekennzeichnet sind, also für die Spannungsdifferenz V-V_{ref} nahe zu Null ist;
- Fig. 3a:: eine Anordnung aus zwei dc SQUIDs, bei der ein Teil Iᵢₙ des Betriebsstromes I_{B} des Signal-SQUIDs mit der Spannung V₁ durch die Einkoppelspule 3 des zweiten SQUIDs mit der Spannung V₂ fließt. Der zweite SQUID arbeitet als Verstärker;
- Fig. 3b:: die resultierende Fluss-Spannungs-Kennlinie der Anordnung nach Fig. 3a;
- Fig. 4:: zeigt ein zweistufiges SQUID-System mit interner Rückkopplung. Ein Teil I_{fb} des Betriebsstromes I_{B2} fließt durch die Einkoppelspule 2 des Signal-SQUID und erzeugt so eine Rückkopplung in diesen SQUID.

Die Figuren 1 bis 4 repräsentieren den bekannten Stand der Technik.

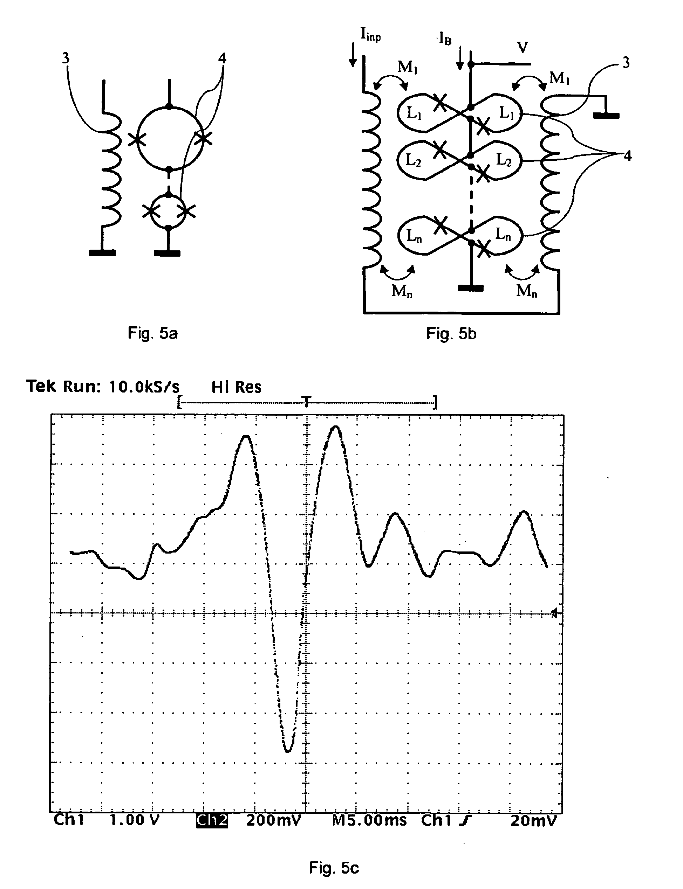

- Fig. 5a:: eine vereinfachte, prinzipielle Darstellung eines SQIFs (4) mit erfindungsgemäß integrierter Enkoppelspule 3, welche in weiteren Abbildungen ein SQIF repräsentieren soll;
- Fig. 5b:: eine SQIF-Anordnung mit integrierter Einkoppelspule. Das SQUIF (4) besteht aus mehreren dc SQUIDs. Jeder dc SQUID ist in diesem Beispiel als Gradiometer aus zwei miteinander zusammengeschalteten Schleifen gebildet. Alle Induktivitäten L₁...Lₙ dieser SQUIDs sind unterschiedlich. Die Einkoppelspule 3 erzeugt einen Fluss in alle SQUIDs des SQIFs mit je unterschiedlicher Gegenkopplung M₁...Mₙ;
- Fig. 5c:: eine experimentell aufgezeichnete Eingangsstrom-Spannungs-Kennlinie eines SQIF, bestehend aus 56 seriell geschalteten unterschiedlichen SQUID. Vertikal: Spannung mit 0,2 mV/div und horizontal der Eingangsstrom mit 10 µA/div;

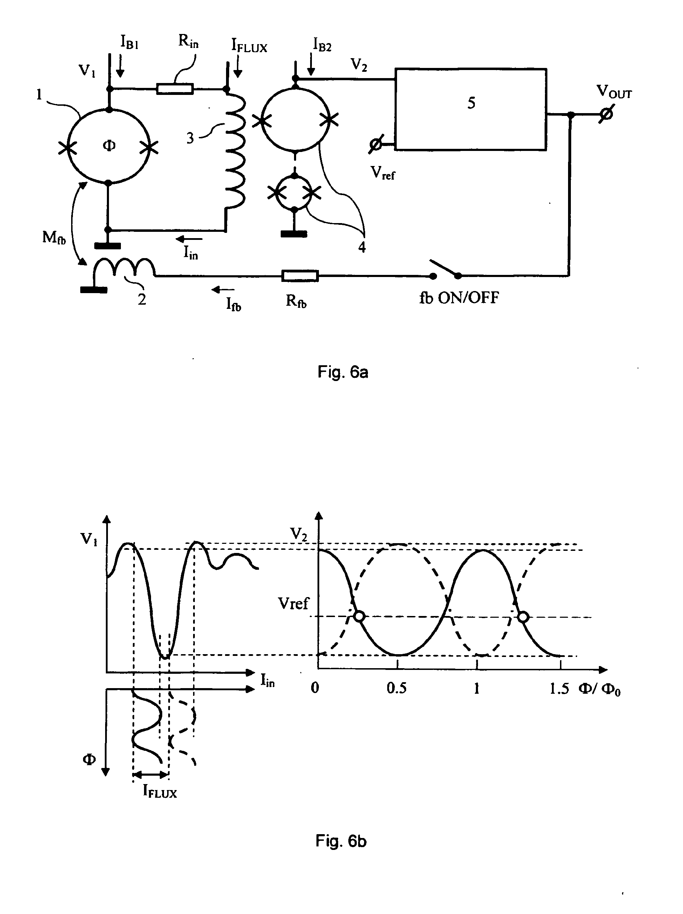

- Fig. 6a:: schematisch eine erste Anordnung aus SQUID und SQIF, welche in vorliegender Erfindung vorgeschlagen wird;
- Fig. 6b:: die Fluss-Spannungs-Kennlinie der Anordnung nach Abb. 6a ohne Rückkopplung, d.h. der Schalter (fb) ist offen, also in der Stellung "OFF";

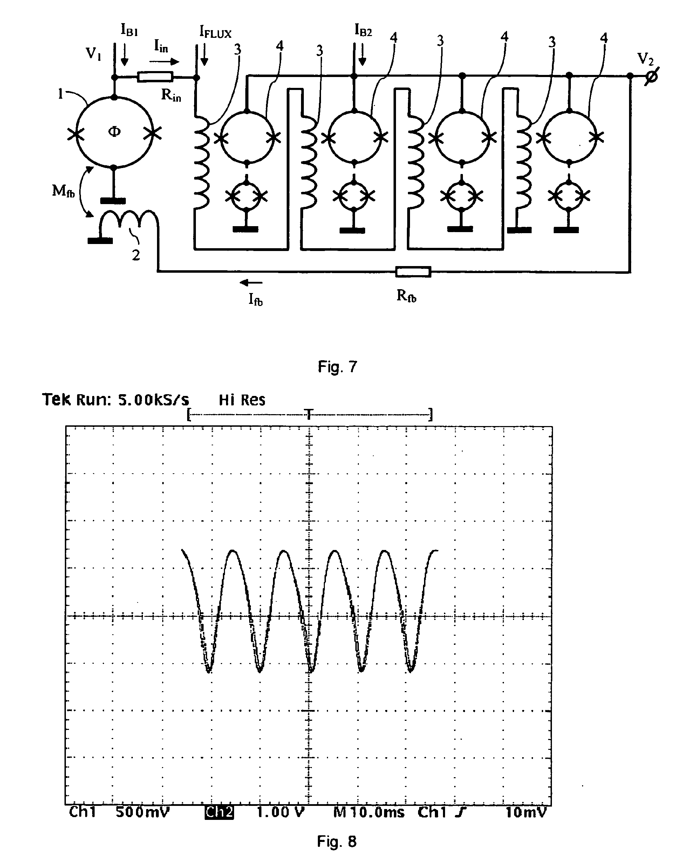

- Fig. 7:: ein weiteres schematisches Schaltungsbeispiel einer Anordnung aus SQUID 1 und SQIF 4 mit interner Rückkopplung. Um eine bessere Ruckkopplung zu gewährleisten, wurden in diesem Beispiel vier gleiche SQIFs zusammengeschaltet, so dass die SQIFs parallel und deren Einkoppelspulen 3 seriell verbunden sind;
- Fig. 8:: zeigt eine experimentell gemessene Fluss-Spannungs-Kennlinie einer Anordnung aus einem Magnetometer-SQUID und einem SQIF, der im Beispiel aus 56 seriell geschalteten SQUIDs besteht. Dabei bezeichnet die vertikale Achse: Spannung V₂ mit 1 mV/div.; die horizontale Achse: Magnetfeld in willkürlichen Einheiten und

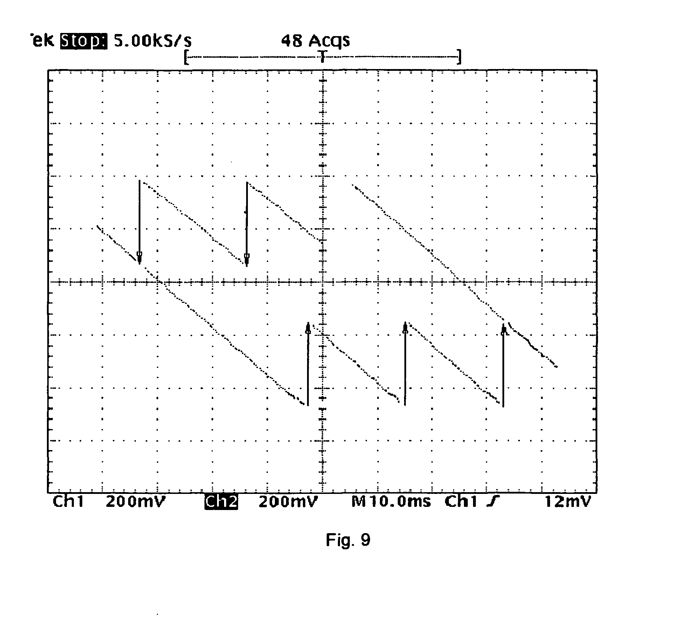

- Fig. 9:: zeigt eine Aufzeichnung der Fluss-Spannungs-Kennlinie des SQUID-SQIF Systems mit interner Rückkopplung nach Fig. 7. Dabei bezeichnet die vertikale Achse: Spannung V₂ mit 0.2 mV/div.; die horizontale Achse: Magnetfeld in willkürlichen Einheiten. Die Pfeile repräsentieren die Sprünge in der Kennlinie, bei denen ein magnetisches Flussquant das Magnetometer-SQUID verlässt oder hinzukommt.

Zum leichteren Verständnis der Erfindung soll zunächst, anhand der Figuren 1 bis 4, der bislang nach dem Stand der Technik übliche Weg zur Verstärkung der Signale eines dc SQUID skizziert werden: Dazu zeigt Fig. 1a zunächst einen einzelnen dc SQUID 1 und Fig. 1b die Strom-Spannungs-Kennlinie (I-V-Kennlinie) des dc SQUID für die zwei Extremalwerte des Flusses (Φ) im SQUID, wobei Φ₀ für ein Flussquant steht. Fig. 1c zeigt die zugehörige Fluss-Spannungs-Kennlinie (Φ-V-Kennlinie) des SQUID, wenn es mit einem Betriebsstrom I_{B} gespeist wird. Fig. 2a zeigt einen dc SQUID 1 mit üblicher Rückkoppelelektronik. Falls der Schalter fb ON/OFF geschlossen (Stellung "ON") ist, erzeugt die Elektronik 5 einen Strom I_{fb} proportional zur Spannungsdifferenz V-V_{ref} durch den Widerstand R_{fb} und die Rückkoppelspule L_{fb}. Figur 2b zeigt die zugehörige SQUID-Spannung als Funktion des Flusses im SQUID. Der Rückkoppelkreis hält den Gesamtfluss im SQUID konstant in der Nähe der Arbeitspunkte, die durch die Kreise in Fig. 2b gekennzeichnet sind, also für die Spannungsdifferenz V-V_{ref} nahe zu Null ist.

Figur 3a zeigt eine prinzipielle zweite Schaltungsmöglichkeit nach dem Stand der Technik, die eingangs bereits erwähnt wurde, nämlich eine Anordnung bestehend aus zwei dc SQUIDs 1, bei der ein Teil Iᵢₙ des Betriebsstromes I_{B} des Signal-SQUIDs mit der Spannung V₁ durch die Einkoppelspule 3 des zweiten SQUIDs mit der Spannung V₂ fließt. Der zweite SQUID (rechts im Bild) arbeitet dabei als Verstärker. Die sich bei einer solchen Schaltung ergebenden Nachteile sind aus Fig. 3b deutlich ersichtlich, die die resultierende Fluss-Spannungs-Kennlinie der Anordnung im rechten Bildteil wiedergibt.

Figur 4 repräsentiert eine weitere nach dem Stand der Technik bekannte Schaltungsvariante. Hier ist ein zweistufiges SQUID-System mit interner Rückkopplung dargestellt. Ein Teil I_{fb} des Betriebsstromes I_{B2} des zweiten SQUID fließt durch die Rückkoppelspule 2 des Signal-SQUID und erzeugt so eine Rückkopplung in den ersten SQUID 1.

Alle vorstehenden Varianten stellten den bislang bekannten Stand der Technik mit seinen Nachteilen dar. Ab hier erfolgt nun eine detaillierte spezielle Ausführung vorliegender Erfindung.

Dazu wird zunächst auf Fig. 5a verwiesen, die eine vereinfachte, prinzipielle Darstellung eines SQIFs 4 mit erfindungsgemäß integrierter Einkoppelspule 3 zeigt, welche in weiteren Abbildungen das SQIF 4 repräsentieren soll, egal, wie es im speziellen weiter ausgebildet ist.

Als erstes wird erfindungsgemäß vorgeschlagen, im SQIF 4 allen Schleifen des SQIF eine Einkoppelspule 3 zuzuordnen (integrieren), die magnetischen Fluss produzieren kann. Wenn kein externes Magnetfeld anliegt, dann wird der Fluss im SQIF 4 vom Strom durch die Einkoppelspule 3 bestimmt. Die Spannung über dem SQIF, bei Anlegen des entsprechenden Arbeitsstromes, zeigt dann über dem Einkoppelstrom aufgetragen einen starken Peak (Minimum) bei einem Strom der Amplitude Null. Der Betrieb dieser SQIF mit integrierter Einkoppelspule ist nur möglich, wenn der externe magnetische Fluss in allen SQIF-Schleifen vernachlässigbar ist. Sonst kann der Spannungspeak nur in wenigen speziellen Fällen gefunden werden.

Zur Behebung vorstehend erwähnten Problems wird erfindungsgemäß weiterhin vorgeschlagen, die einzelnen SQIF-Schleifen in Form von zwei geometrisch gleich großen, symmetrisch zueinander angeordneten Schleifen auszuführen, die so verbunden werden, dass der Fluss, der durch ein externes Magnetfeld erzeugt wird, Null ist (Gradiometeranordnung). Dadurch lässt sich der Einfluss des externen Magnetfeldes reduzieren. Vorstehend beschriebene spezielle Ausführung ist in Fig. 5b schematisch angedeutet. Dort ist eine SQIF-Anordnung 4 mit integrierter, seriell geschalteter Einkoppelspule 3 schematisch dargestellt. Das SQUIF 4 besteht aus mehreren dc SQUIDs. Jeder dc SQUID ist in diesem Beispiel als Gradiometer aus zwei miteinander zusammengeschalteten Schleifen gebildet. Alle Induktivitäten L₁...Lₙ dieser SQUIDs sind unterschiedlich. Die Einkoppelspule erzeugt einen Fluss in allen SQUIDs des SQIFs mit je unterschiedlicher Gegenkopplung M₁...Mₙ. Die hier gezeigte Anordnung kann auch in den weiterhin dargestellten Schaltungsanordnungen nach

Fig. 6a und Fig. 7 Einsatz finden, auch wenn dort nur von der Prinzipdarstellung nach Fig. 5a aus Übersichtsgründen Gebrauch gemacht wird.

Vorstehende Vorschläge wurden im Rahmen der Erfindung experimentell verifiziert. Im speziellen Beispiel wurde ein SQIF gebaut, welches aus 56 Gradiometer-dc SQUIDs besteht. Die zwei Schleifen jedes Gradiometer-SQUID wurden seriell verschaltet. Auf jeder Schleife ist eine Einkoppelspule integriert. Ein Beispiel für eine experimentell so gemessene Spannungs-Einkoppelstrom-Kennlinie des SQIF-Stromsensors wird in der Fig. 5c gezeigt. Vertikal: Spannung mit 0,2 mV/div und horizontal der Eingangsstrom mit 10 µA/div (vgl. Fig. 5c). Es soll erwähnt werden, dass die Messung ohne magnetische Abschirmung erfolgte. Das bedeutet, der SQIF war dem Erdmagnetfeld ausgesetzt. Die vorliegend modifizierten SQIF-Sensoren eignen sich für den Einsatz in der erfindungsgemäß vorgeschlagenen zweistufigen SQUID-Auslese mit SQIF.

In Fig. 6a wird beispielhaft ein solches erstes SQUID-SQIF-System als ausführlicherer Teil der Gesamtschaltung schematisch gezeigt. Der SQIF 4 wird dabei durch die Serienschaltung einer Reihe verschiedener SQUID repräsentiert, was durch die unterbrochene Linie zwischen den unterschiedlichen SQUIDs des SQIF angedeutet ist (vgl. auch Fig. 5a). Die Einkoppelspule 3 ist induktiv an jeden SQUID des SQIF mit der Gegenkopplungsinduktivität M₁ bis Mₙ angekoppelt. Im Ergebnis einer solchen erfindungsgemäßen Schaltungsanordnung weist dann die Abhängigkeit der SQIF-Spannung V₂ vom Einkoppelstrom Iᵢₙ ein scharfes Minimum auf, wie es in der Fig. 6b gezeigt ist. Die Spannung V₁ über dem ersten SQUID 1 erzeugt über dem Widerstand Rᵢₙ einen Strom durch die Einkoppelspule 3 des SQIF 4. Um den besten Arbeitspunkt des Systems einzustellen, wird eine weitere Stromquelle benötigt, die über einen Strom I_{FLUX} durch die Einkoppelspule des SQIF einen Fluss im SQIF erzeugt. Der Fluss im SQIF 4 ist deswegen die Summe aus dem Signal vom ersten SQUID 1 V₁/Rᵢₙ und dem Offset-Fluss durch den Strom I_{FLUX} einer zusätzlichen Stromquelle (in Fig. 6a nicht gezeigt). Die periodische Spannungsmodulation des ersten SQUIDs 1, aufgrund der Flussänderung (Φ) im SQUID 1, erzeugt eine Strommodulation von Iᵢₙ und damit eine sich ändernde SQIF-Spannung V₂. Um eine maximale Modulation der Spannung V₂ zu erreichen, muss die Amplitude des Offsetstroms I_{FLUX} so eingestellt werden, dass die Modulation des Stroms Iᵢₙ an der steilsten Stelle der SQIF-Kennlinie erfolgt. Dabei ist klar, dass aufgrund der Form der Kennlinie nur zwei solche Arbeitspunkte existieren. Als Ergebnis erhält man eine Fluss (Φ)-SQIF-Spannungs-(V₂)-Kennlinie, die wie die Fluss-Spannungs-Kennlinie eines Einzel-SQUIDs aber mit deutlich größerer Amplitudenmodulation der Spannung aussieht (vgl. Fig. 6b rechts). Es sind, ähnlich wie für ein Einzel-SQUID, periodische Arbeitspunkte (Kreise in Fig. 6b rechts) vorhanden, um die die Kennlinie wieder mit einer FLL linearisiert werden kann (vergleiche auch Fig. 2b). Die SQIF-Spannung V₂ kann bspw. von der FLL oder auch einer einfacheren Verstärkerschaltung 5 verstärkt werden, welche das Rückkoppelsignal erzeugt, das durch die Rückkoppelspule 2 auf das ersten SQUID 1 gekoppelt wird, wenn der Schalter fb in der Stellung "ON" ist. Bis auf einen höheren Fluss-Spannungs-Transferfaktor der SQUID-SQIF-Schaltung kann die Kennlinie wie bei einem Einzel-SQUID ansonsten fachgemäß linearisiert werden.

Im Rahmen der Erfindung wird weiterhin vorgeschlagen, den SQIF mit integrierter Einkoppelspule zum Aufbau einer SQUID-SQIF-Anordnung mit interner Rückkopplung zu verwenden. Der grundsätzliche schematische Aufbau einer solchen Anordnung wird in der Fig.7 gezeigt.

Da jeder SQIF nur einen limitierten Strom treiben kann, ohne die Amplitude des Spannungspeaks zu verlieren, wird erfindungsgemäß weiterhin vorgeschlagen, eine vorgebbare Anzahl von SQIFs 4 parallel zu schalten, um einen größeren Strom durch die Spule 3 des ersten SQUID 1 zu ermöglichen. Ein schematischer Aufbau einer solchen Schaltungsausbildung ist in der Fig. 7 gezeigt. Man erkennt dort eine Anordnung aus SQUID und SQIF mit interner Rückkopplung. Zur Erreichung der besseren Ruckkopplung, wurden im speziellen Beispiel vier gleiche SQIFs 4 zusammengeschaltet, so dass die SQIFs 4 parallel und deren Einkoppelspulen 3 seriell verbunden sind. Ein Teil des Betriebsstromes des SQUIDs I_{B1} fließt durch den Widerstand Rᵢₙ und die Einkoppelspulen 3 der SQIFs 4. Ähnlich wie in der Fig. 6a kann der optimale Arbeitspunkt für die SQIF durch einen zusätzlichen Offsetstrom I_{FLUX} eingestellt werden. Die Rückkopplung wird durch das Fließen eines Teils des Betriebsstromes des SQIFs (V₂/R_{fb}) durch die Rückkoppelspule 2 des ersten SQUID 1, welcher im Rahmen der Erfindung als Stromsensor-, Magnetometer- oder Gradiometer-SQUID ausgeführt werden kann, erreicht. Das System mit interner Rückkopplung findet automatisch einen stabilen Arbeitspunkt und hält den Fluss im ersten SQUID 1 konstant. Jede Änderung durch einen externen Fluss wird durch einen Strom I_{fb} durch die Rückkoppelspule 2 kompensiert, so dass die Ausgangsspannung V₂ proportional zur Änderung des externen Flusses ist. Wenn die Amplitude des externen Flusses die Grenze der möglichen Rückkopplung erreicht, verliert das System den Arbeitspunkt und springt auf den nächst möglichen stabilen Arbeitspunkt, wobei ein magnetisches Flussquant (Φ₀) den SQUID 1 verlässt. Diese Sprünge in der Ausgangsspannung stammen aus der Φ₀-Periodizität der SQUID-Kennlinie.

Um die Wirkungsweise der erfindungsgemäßen SQUID-SQIF-Anordnung und entsprechendes Erhöhen des Transferfunktion zu demonstrieren, wurde zunächst ein solches System ohne interne Rückkopplung (die als solche, ja eine weitere erfindungsgemäße Ausgestaltung betrifft) aus einem hochempfindlichen Magnetometer und aus zuvor beschriebenem SQIF aufgebaut. Die gemessene Fluss-Spannungs-Kennlinie des Systems ist in der Figur 8 gezeigt. Die Kennlinie ist sehr ähnlich zur Kennlinie des einzelnen Magnetometer-SQUID, bis auf das erfindungsgemäß angestrebte Ziel, dass die Kennlinie dieser Anordnung einen um den Faktor 20 höheren Spannungs-Fluss-Transferfaktor aufweist.

Die zuvor beschriebenen SQIF wurden anschließend genutzt, um eine Anordnung mit interner Rückkopplung aufzubauen. Im speziellen Beispiel wurden vier der SQIF parallel geschaltet. Die Einkoppelspulen der SQIF wurden seriell verschaltet. Die Spannung des Magnetometer-SQUID wurde mit einem Widerstand in einen Strom gewandelt, der durch die Einkoppelspulen der SQIF fließt, wie in Fig. 7 prinzipiell dargestellt. Die gemessene Fluss-Spannungs-Kennlinie dieser Anordnung ist in Fig. 9 gezeigt. Dabei bezeichnet die vertikale Achse: Spannung V₂ mit 0.2 mV/div.; die horizontale Achse: Magnetfeld in willkürlichen Einheiten. Die Pfeile im Graphen repräsentieren die Sprünge in der Kennlinie, bei denen ein magnetisches Flussquant das Magnetometer-SQUID 1 verlässt oder hinzukommt.

Deutlich ist die Linearisierung der Kennlinie zu erkennen. Wenn die Ausgangsspannung einen Grenzwert erreicht, dann erfolgt ein Sprung um ein magnetisches Flussquant. Neben der allein durch die vorgeschlagene Schaltungsanordnung erreichten Linearisierung der Kennlinie, ohne die Verwendung einer FLL-Elektronik, ergibt sich der gewünschte Vorteil, dass die Ausgangsspannung deutlich größer ist, als die eines Einzel-SQUIDs. Dadurch erniedrigen sich die Anforderungen an nachfolgende, außerhalb vorliegender Erfindung liegende, und deshalb hier nicht näher dargestellte weitere Elektronikschaltungen.

Alle in der Beschreibung, den Ausführungsbeispielen, den Ansprüchen und/oder Zeichnungen angegebenen Merkmale können sowohl einzeln als auch in beliebiger Kombination miteinander erfindungswesentlich sein.

## Patentansprüche

1. Schaltungsanordnung zum Betreiben eines dc SQUID zur Erreichung einer erhöhten Fluss-Spannungs-Transferfunktion, **dadurch gekennzeichnet, dass** zumindest ein SQIF (4) als Verstärkerschaltung vorgesehen ist, welches dem ersten SQUID (1) nachgeordnet ist, wobei allen Schleifen des SQIF (4) eine und dieselbe mit dem ersten SQUID (1) elektrisch verbundene Einkoppelspule (3) zwecks induktiver Ankopplung, direkt zugeordnet ist.

2. Schaltungsanordnung nach Anspruch 1, **dadurch gekennzeichnet, dass** das SQIF (4) aus mehreren elektrisch parallel zueinander geschalteten einzelnen SQIFs (4) gebildet ist, denen jeweils eine **einzige** Einkoppelspule (3) zugeordnet ist, die ihrerseits in Serie geschaltet sind.

3. Schaltungsanordnung nach Anspruch 1 oder 2, **dadurch gekennzeichnet, dass** jedes SQIF (4) aus mehreren untereinander unterschiedlich ausgebildeten dc SQUIDs besteht, wobei jeder einzelne dc SQUID als Gradiometer aus zwei miteinander zusammengeschalteten Schleifen gebildet ist.

4. Schaltungsanordnung nach Anspruch 1 oder 2, **dadurch gekennzeichnet, dass** die SQIF-Spannung (V₂) direkt am SQIF-Ausgang abgenommen wird und das Rückkoppelsignal (I_{fb}) erzeugt, das durch eine Rückkoppelspule (2) auf das ersten SQUID (1) gekoppelt wird.

5. Schaltungsanordnung nach Anspruch 1 oder 2, **dadurch gekennzeichnet, dass** die SQIF-Spannung (V₂) von einer FLL oder auch einer einfacheren Verstärkerschaltung (5) verstärkt wird, welche das Rückkoppelsignal (I_{fb}) erzeugt, das durch eine Rückkoppelspule (2) auf das ersten SQUID (1) gekoppelt wird.

6. Schaltungsanordnung nach einem der vorstehenden Ansprüche,
**dadurch gekennzeichnet, dass** zwecks Einstellung des besten Arbeitspunkts des Systems der Einkoppelspule (3) des SQIF (4) eine zusätzliche Stromquelle zugeordnet ist, die über einen Strom I_{FLUX} einen voreinstellbaren Fluss im SQIF (4) erzeugt.

## Claims

1. Circuit arrangement for operating a dc SQUID to obtain an increased flux-voltage-transfer function, **characterized in that** at least one SQIF (4) is provided as an amplifier circuit being arranged downstream relative to the first SQUID (1), wherein, for inductive coupling, one and the same input coil (3) electrically connected to said first SQUID (1) is directly coupled to all loops of the SQIF (4).

2. Circuit arrangement as claimed in claim 1, **characterized in that** the SQIF (4) is constituted of a plurality of single SQIFs (4) being electrically connected in parallel to one another to each of which only one input coil (3) is associated, which in turn, being series connected.

3. Circuit arrangement as claimed in claim 1 or 2, **characterized in that** each SQIF (4) consists of a plurality of mutually differently designed dc SQUIDS, wherein each single dc SQUID as a gradiometer is formed of two interconnected loops.

4. Circuit arrangement as claimed in claim 1 or 2, **characterized in that** the SQIF voltage (V₂) pick-off takes place directly at the SQIF output and generates the feedback signal (I_{fb}) which is coupled via a feedback coil (2) to the first SQUID (1).

5. Circuit arrangement as claimed in claim 1 or 2, **characterized in that** the SQIF voltage (V₂) is amplified by an FLL or only by a simpler amplifier circuit (5) which generates the feedback signal (I_{fb}) which is coupled via a feedback coil (2) to the first SQUID (1).

6. Circuit arrangement as claimed in one of the preceding claims, **characterized in that**, for setting the best operation point of the system, an auxiliary current source is associated to the input coil (3) of the SQIF (4) which source via a current I_{FLUX} generates a presettable flux in SQIF (4).

## Revendications

1. Configuration du circuit destiné à exploiter un dc SQUID pour fournir un transfert flux-tension accrue, est **caractérisée en ce qu'** à cet effet au moins un SQIF (4) monté en aval du premier SQUID (1), est prévu de servir de montage amplificateur; une seule et même bobine d'alimentation (3), électriquement reliée au premier SQUID (1), étant directement associée à toutes les boucles du SQIF (4) aux fins d'un couplage inductif.

2. Configuration du circuit suivant la revendication 1 est **caractérisée en ce que** le SQIF (4) se compose de plusieurs SQIF (4) individuels électriquement reliés en parallèle entre eux, à chacun d'entre eux étant attribué une bobine d'alimentation (3) individuel qui de son côté est montée en série avec les bobines attribuées aux autres SQUIF.

3. Configuration du circuit suivant les revendications 1 ou 2 est **caractérisée en ce que** chaque SQIF (4) se compose de plusieurs SCUIDS (4) de configurations différentes et servant tous de gradiomètres composés de deux boucles reliées entre elles.

4. Configuration du circuit suivant les revendications 1 ou 2 est **caractérisée en ce que** la tension SQIF (V₂) prise directement à la sortie SQIF, produit le signal de rétro-action (I_{fb}) qui ensuite est couplé par une bobine de rétro-action (2) au premier SQUID (1).

5. Configuration du circuit suivant les revendications 1 ou 2 est **caractérisée en ce que** la tension SQIF (V₂) est amplifiée par FLL (flux-locked loop) ou un simple circuit amplificateur (5) émettant le signal de rétro-action ((I_{fb}) couplé par une bobine de rétro-action (2) au SQUID (1).

6. Configuration du circuit suivant une des revendications précédentes est **caractérisée en ce que** dans le but de trouver, par voie de réglage, le meilleur point de travail pour le système, une source supplémentaire de courant est attribuée à la bobine d'alimentation (3) du SQIF (4) afin de générer par l'intermédiaire d'un courant I_{FLUX} un flux préréglable au sein du SQIF (4).
